# EUROPEAN PATENT APPLICATION

(11) **EP 2 514 576 A1**
(43) Date of publication of application: **24.10.2012**
(21) Application number: 12164579.0
(22) Date of filing: 18.04.2012
(51) Int. Cl.: B28D 1/22, H05K 3/00, B28D 5/00

(54) **A method of producing ceramic substrates**

(30) Priority: 19.04.2011 JP 2011092651
(71) Applicant: NGK Insulators, Ltd., Nagoya-shi, Aichi 467-8530 (JP)
(72) Inventor: Miyazawa, Sugio, Nagoya-shi, Aichi 467-8530 (JP); Watanabe, Keiichiro, Nagoya-shi, Aichi 467-8530 (JP); Ohashi, Tsuneaki, Nagoya-shi, Aichi 467-8530 (JP)
(74) Representative: TBK

(57) **Abstract**

A ceramic base plate is divided into a plurality of substrate regions 2 each having corner part 8. A dividing groove 7 is formed between the substrate regions 2 adjacent with each other. The corner part 8 of each of the substrate regions 2 faces a spacing 9B communicated with the dividing groove 7. At least a part of the corner part 8 is arc-shaped. The arc-shaped part of the corner part is tangent to a center line 7a of the dividing groove 7 at a cross point "P" of the spacing 9B with the dividing groove 7. The ceramic base plate is broken along the dividing groove 7 to produce ceramic substrates.

## Description

### BACKGROUND OF THE INVENTION

### 1. Field of the Invention

The present invention relates to a method of producing ceramic substrates by breaking a ceramic base plate.

### 2. Background Arts

Alumina ceramics has been widely used for a substrate for electronic devices owing to its characteristics such as electrical insulation and chemical stability. In producing such substrates, many substrate regions are provided in a single base plate of a large area, for facilitating its handling and for improving subsequent production efficiency of electronic devices such as printing of wiring patterns and mounting of semiconductor devices. In producing such substrates, breaking grooves (dividing grooves) are formed on a surface of the base plate for facilitating the breaking into respective pieces. Such dividing grooves may be formed by producing a ceramic unfired green sheet shaped by doctor blade or the like, forming cuttings on the surface of the green sheets by pressing a cutter blade or press metal mold thereon, and then firing the green sheet (Japanese Patent Nos. 3,330,104B and 3,876,259B).

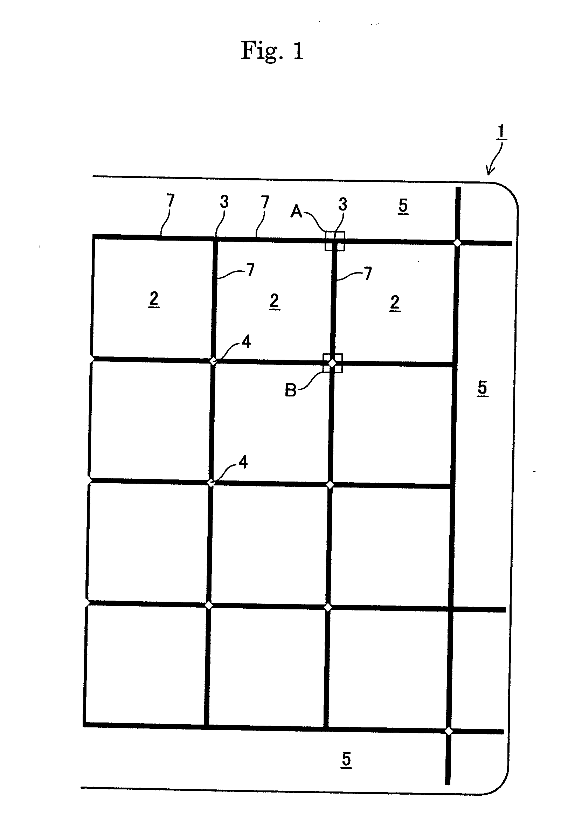

Here, for example as shown in Fig. 1, spacings are formed at crossing parts A and B of each of the pieces (each of the ceramic substrate regions) 2. Various techniques have been proposed about the shape of the spacing (Japanese Patent Publication No. 1982-197,889A; Japanese Patent Publication No. 1990-133,987A; Japanese Utility Model Publication No. 1982-181,060A; Japanese Utility Model Publication No. 1983-049,464A; Japanese Utility Model Publication No. 1985-066,061A; Japanese Patent Publication No. 2008-060,096A; and Japanese Patent Publication No. 1994-091,628A).

Besides, it is descried, in Japanese Patent Publication No. 2001-335,371A, a method of producing a translucent ceramic substrate by gel cast molding.

### SUMMARY OF THE INVENTION

According to the prior arts, in breaking a base plate along dividing grooves, the base plate may be broken along a line different from the dividing grooves to result in a reduction of yield. It is possible to assist the breaking along the dividing groove by making the groove deeper toward the bottom face of the base plate. In this case, however, the mechanical strength of the base plate would be considerably lowered so that the base plate may be easily broken during handling for printing etc.. It is thus impossible to make the dividing groove deeper than a predetermined depth.

An object of the present invention is to produce ceramic substrates by breaking a ceramic base plate along dividing grooves so that it can be broken along the dividing grooves.

The present invention provides a method of producing a plurality of ceramic substrates by breaking a ceramic base plate,
wherein the ceramic base plate comprises a plurality of substrate regions divided with each other, the substrate region comprising a corner part;
wherein a dividing groove is formed between the substrate regions adjacent with each other;
wherein the corner part of each of the substrate regions faces a spacing communicated with the dividing groove;
wherein at least a part of the corner part has a shape of an arc; and
wherein the arc-shaped part of the corner part is tangent to a center line of the dividing groove at a cross point of the spacing with the dividing groove;
the method comprising the step of producing the ceramic substrates by breaking the ceramic base plate along the dividing groove.

According to the present invention, in breaking the base plate along the dividing grooves, it is possible to prevent the fracture of the base plate along a line different from the dividing grooves.

These and other objects, features and advantages of the invention will be appreciated upon reading the following description of the invention when taken in conjunction with the attached drawings, with the understanding that some modifications, variations and changes of the same could be made by the skilled person in the art.

### BRIEF DESCRIPTION OF THE DRAWINGS

Fig. 1 is a plan view schematically showing a ceramic base plate 1.
Fig. 2 is a plan view showing an enlarged view of part "A" of the base plate 1 of Fig. 1, and Fig. 2 (b) is a cross sectional view of the "A" part of Fig. 2 (a).
Fig. 3 is a plan view showing an enlarged view of part "B" of the base plate 1 of Fig. 1, and Fig. 3(b) is a cross sectional view of the "B" part of Fig. 2 (a).
Fig. 4 is a diagram showing positional relationship of a central line of a dividing groove and a corner part of a substrate region, according to the present invention.
Fig. 5 (a) is a plan view showing shapes and positional relationship of a spacing and a dividing groove according to a comparative example, and Fig. 5 (b) is an enlarged view showing a region "E" in the vicinity of an end part of the dividing groove and an end part of the spacing.

### Embodiments of the invention

As shown in Fig. 1, a ceramic base plate 1 is divided into a plurality of substrate regions 2, and a dividing groove is formed between the adjacent substrate regions 2. At crossing parts 3 and 4 of the respective corner parts of the substrate regions 2, spacings are formed, respectively, so that the spacings are communicated with the dividing grooves. A reference numeral 5 represents a non-used region which is not used in a product. In Fig. 1, corner parts of the two substrate regions cross at the crossing part 3, and corner parts of the four substrate regions cross at the crossing part 4.

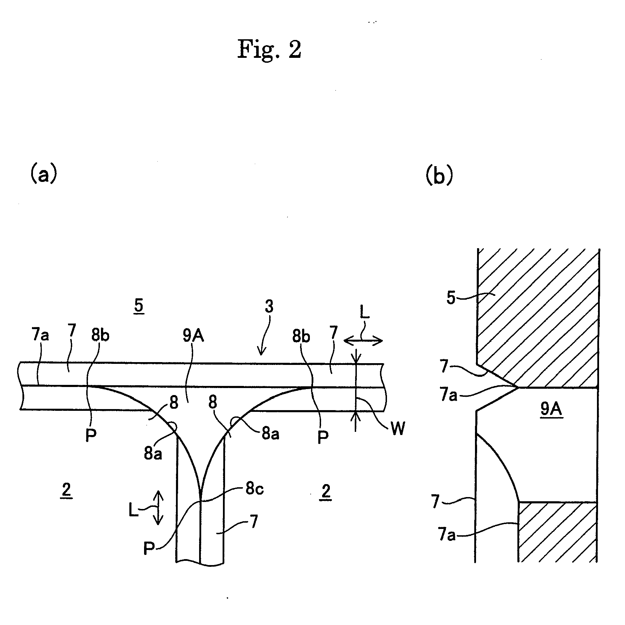

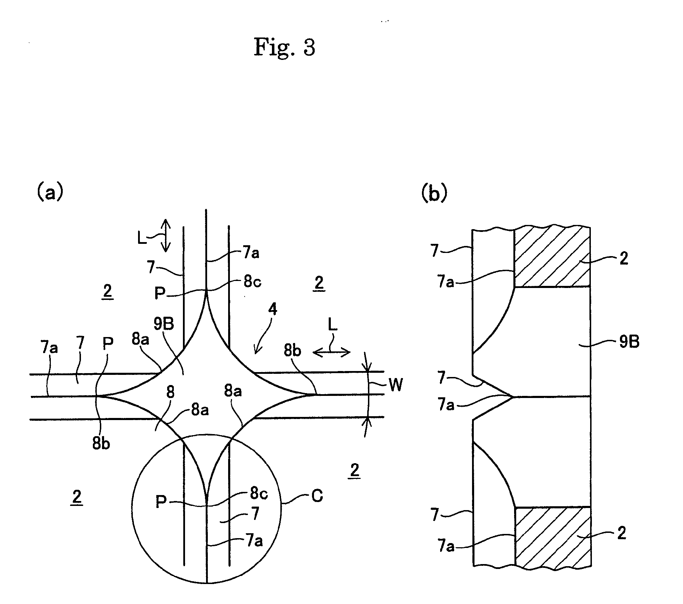

Figs 2 and 3 show enlarged views of regions "B" and "C" in the vicinity of the crossing parts. In Fig. 2, a spacing 9A is defined by the adjacent two substrate regions 2 and the unused region 5. A corner part 8 faces a spacing 9A of the substrate region 2 and has a shape of an arc in a plane of the surface of the base plate 2. The center of curvature of each of the corner parts 8 is located inside of the corner part 8 (inside of the substrate region 2). The spacing 9A and dividing groove 7 contact each other at a crossing point "P". "L" represents the longitudinal direction of each dividing groove.

Further, as shown in Fig. 3, a spacing 9B is defined by the adjoining four substrate regions 2. A corner part faces the spacing 9B of the substrate region 2 and has a shape of an arc in a plane of the surface of the base plate. The center of curvature of each of the corner parts 8 is located inside of the corner part 8 (inside of the substrate region 2). The spacing 9B and dividing groove 7 contact each other at a crossing point "P". "L" represents the longitudinal direction of each dividing groove.

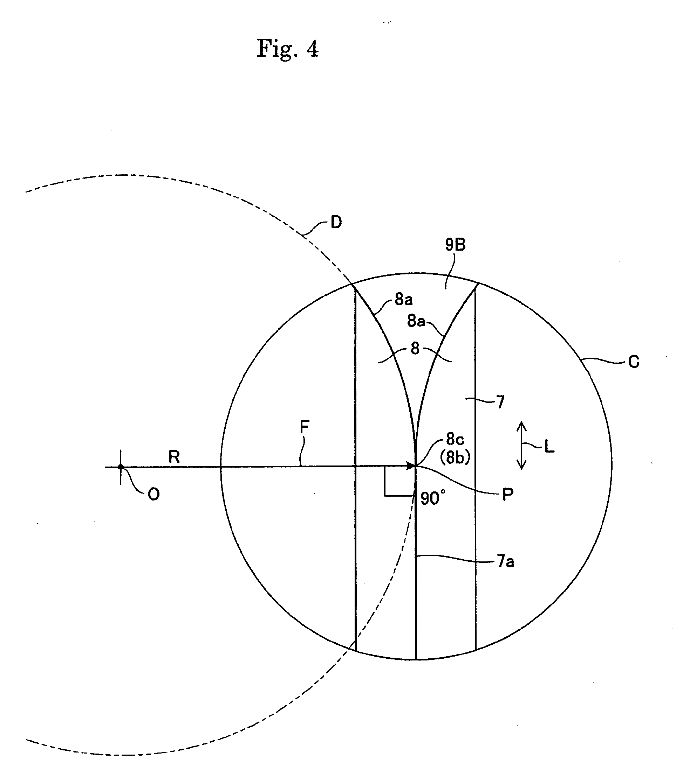

Fig. 4 is an enlarged view showing a region in the vicinity of each contact point of the dividing groove and spacing. That is, "D" represents a virtual circle obtained by extending the outline of the corner part 8, "O" represents a center of curvature of the virtual circle "D", and "R" represents a radius of curvature of the circle. The end part 8c (or 8b) of the corner part 8 is present on the cross point "P" of the spacing 9B (or 9A) and the center line 7a of the dividing groove 7. According to the present invention, the corner part 8 is tangent to the center line 7a (the center line in a plan view) of the dividing groove 7. In other words, at the cross point "P" (or end part 8c, 8b of the corner part) of the virtual circle "D", the outline (along the virtual circle "D") of the corner part 8a is parallel with the longitudinal direction "L" of the center line 7a of the dividing groove 7. Further, provided that a radial line "F" is drawn from the center "O" of the virtual circle to the cross point "P", the radial line "F" is perpendicular to the center line 7a.

According to the present invention, when the ceramic base plate is broken along the dividing grooves, it is possible to prevent the breaking at positions different from the dividing grooves and unnecessary crack formation therein, so that the ceramic base plate can be assuredly broken and the yield can be improved.

In the case that the dividing groove is formed by a cutter blade or press blade, the angle of the groove should be small due tho the limitation of the production. This results in the groove with a very small width, so that a part of the opening of the groove tends to be closed during the sintering step to result in deterioration of the ease of breaking. Thus, according to a preferred embodiment, the dividing groove is defined by at least a first inclined face and a second inclined face and the both faces make an angle of 25 to 90 ° , in a cross section perpendicular to the longitudinal direction "L" of the dividing groove. It is thereby possible to prevent the close of the groove opening during the sintering and the partly deterioration of the breaking characteristic, so that the deviation of the strength required for the breaking step can be reduced.

Further, according to a preferred embodiment, the width "W" of the opening of the dividing groove is 0.1 to 0.5 mm at the surface of the ceramic base plate.
According to the present invention, at least a part of the corner part 8 has a shape of an arc in a plan view. Here, it is preferred that the arc-shaped part of the corner part 8 is continuously formed with the end part 8b or 8c. In this case, it is preferred that the corner part has a shape of an arc in a range of 30 ° or more, more preferably 45 ° or more, with respect to the end part 8b or 8c. It is further preferred that 30 percent or more, more preferably 50 percent or more, of the length of the outline of the corner part 8 has a shape of an arc. Parts other than the arc-shaped part of the corner part may preferably be a straight line which is tangent to the arc-shaped part. It is further preferred that the outer outline of the corner part 8 has a shape of an arc over the whole length.

The radius of curvature "R" of the corner part 8 (radius "R" of the virtual circle "D") may preferably be 0.2 to 5.0 mm and more preferably be 0.5 to 2.5 mm, on the viewpoint of the present invention.

Further, according to the present invention, it is required that the above described conditions are satisfied at the crossing parts 3 and 4 (A and B) where a plurality of the substrate regions cross. However, at a crossing part where one substrate region 2 and the unused region 5 contact with each other, the base plate is not to be broken between the two substrate regions. Therefore, the above described conditions of the present invention may or may not be satisfied.

The material forming the ceramic base plate is not particularly limited as far as it is used for an electronic device, and includes alumina, magnesia, silica, yttria, silicon nitride, boron nitride, titanium nitride, aluminum nitride, aluminum oxynitride, spinel, yttirum-aluminum garnet and the like.

The present invention is particularly suitable to a dense alumina and particularly translucent alumina. It will be further described below about a ceramic substrate made of translucent alumina etc..

Translucent ceramics, particularly translucent alumina, may be used for a diffusion plate for a light emitting diode device, so that the operational life of the light emitting diode can be considerably improved.

The thickness of the translucent ceramic substrate may preferably be 0.05 mm or more and 2 mm or less. In the case that the substrate is too thin, it may be susceptible to shock or the ratio of in-line transmittance becomes too high to result in shortage of light diffusion. In the case that the ceramic substrate is too thick, the total light transmittance becomes too low and the heat dissipation characteristic becomes low.

The in-line transmittance of the translucent ceramic substrate in visible light range may preferably be 65 percent or less and more preferably be 10 percent or less, on the viewpoint of light diffusion. The total light transmittance of the translucent ceramic substrate may preferably be 90 percent or more on the viewpoint of efficiency of light emission.

The crystal grain size of a ceramics forming the translucent ceramic substrate is not particularly limited and may preferably be 0.1 µm or larger and more preferably be 1 µm or larger, on the viewpoint of obtaining an appropriate translucent characteristic. Further, the crystal grain size of the ceramics may preferably be 100 µm or smaller and more preferably be 40 µm or smaller.

Further, the relative density of the ceramics forming the translucent ceramic substrate may preferably be 98 percent or higher and more preferably be 99 percent or higher, on the viewpoint of assuring the translucent characteristics. Light incident into the ceramics is scattered by pores in the ceramics so that the total light transmittance is considerably lowered.

The molding method of the ceramic substrate is not particularly limited, and may be any method such as doctor blade, extrusion and gel cast molding methods. More preferably, the ceramic substrate is produced using gel cast molding. According to a preferred embodiment, slurry containing ceramic powder, a dispersant and a gelling agent is molded and then gelled to obtain a molded body, which is then sintered (Japanese Patent Publication No. 2001-335371A).
In the case of prior methods of forming grooves by pressing a cutter blade or press mold onto an unfired green sheet, micro cracks may be generated under the grooves and the breaking strength may be deviated. It is possible to avoid this problem by shaping the dividing grooves by protrusions formed on a mold using gel cast molding.

More preferably, it is used raw material obtained by adding 150 to 1000 ppm of an aid to a high purity alumina powder having a purity of 99.9 percent or more (more preferably 99.95 percent or more). It may be listed a high purity alumina powder supplied by Taimei Chemical Co. Ltd. as such high purity alumina powder.
The above described aid may preferably be magnesium oxide and includes ZrO₂, Y₂O₃, La₂O₃ and Sc₂O₃.

The average particle diameter of ceramic powdery raw material is not particularly limited, and may preferably be 0.5 µm or less and more preferably 0.4 µm or less, on the viewpoint of densification and improvement of translucent characteristic by sintering at low temperature. More preferably, the average particle diameter of the ceramic powdery raw material is 0.3 µm or less (Primary particle diameter). The lower limit of the average particle diameter is not particularly limited. The average particle diameter of the powdery raw material can be decided by direct observation of the powdery raw material by means of SEM (Scanning type electron microscope).
Besides, the average particle diameter referred to herein means an average value at n = 500 of values of (maximum major axis length + minimum minor axis length)/ 2 of primary particles excluding secondary aggregated particles, in SEM photographs (in optional two areas at a magnitude of × 30000).

The gel cast molding method includes the followings.
(1) A prepolymer functioning as a gelling agent such as polyvinyl alcohol, epoxy resin, phenolic resin or the like is dispersed in a dispersing medium with inorganic powder and a dispersant to produce slurry, which is then molded and gelled and solidified by crosslinking in three dimensional manner using a crosslinking agent.
(2) An organic dispersant having a reactive functional group is chemically bonded with a gelling agent to solidify the slurry.

### EXAMPLES

### (Example 1)

A base plate 1 made of a translucent alumina ceramics was produced as follows. That is, 100 weight parts of alumina powder and 0.025 weight parts of magnesia as powdery raw materials, 30 weight parts of a polybasic acid ester as a dispersant, 4 weight parts of MDI resin as a gelling agent, 2 weight parts of "MALIALIM AKM0351" (trade name, supplied by NOF corporation) as a dispersant, and 0.2 weight parts of triethylamine as a catalyst were mixed to obtain slurry. The slurry was then casted at room temperature into a mold made of an aluminum alloy which has protrusions each having an inverted shape of a dividing groove, maintained at room temperature for 1 hour, and removed from the mold after the solidification. Further, the molded body was maintained at room temperature for 2 hours and then at 90 °C for 2 hours to obtain a dried molded body of powder having a shape of a base plate. It was then calcined at 1200 °C in air to obtain a calcined body. The calcined body was then sintered at 1800 °C in an atmosphere of hydrogen : nitrogen = 3:1 so that the sintered body was densified and made translucent. The shape and pattern of the dividing groove or the like were adjusted by changing the shape and pattern of the protrusions formed on the mold.

However, as shown in Figs 1 to 4, the dividing groove was made V-groove, the corner part of each substrate region was made an arc-shaped, and the dimensions were made as follows.
Width "W" of opening of dividing groove 7: 0.3 mm
Opening angle of dividing groove 7 (an angle of first and second inclined faces): 60 °
Depth of dividing groove 7: 0.26 mm
Thickness of base plate 1: 1.0 mm
Radius "R" of curvature of corner part 8: 0.5 mm
Dimension of each substrate region 2: 25 mm × 25 mm

Ten samples of the base plate were thus produced and broken along the respective dividing grooves. As a result, the deviation of a force required for the breaking was proved to be 0.6 ± 0.1 N/mm. Further, the broken line was not out of the dividing grooves in all of the ten samples.

### (Comparative Example 1)

The base plate was produced according to the same procedure as the Example 1. The base plate had a planar pattern shown in Fig. 1. Further, the dividing groove was made a V-groove, and its dimensions were same as those described in the Example 1. However, the corner parts of each substrate region did not have a shape of an arc and the planar shape of the spacing was made circular.

Ten samples of the base plate were broken along the dividing grooves, respectively. As a result, the deviation of a force required for the breaking was proved to be 0.6 ± 0.3 N/mm. Further, the broken line was out of the dividing grooves in three of the ten samples.

### (Comparative Example 2)

The base plate was produced according to the same procedure as the Example 1. The base plate had a planar pattern shown in Fig. 1. Further, the dividing groove was made a V-groove, and its dimensions were same as those described in the Example 1. However, the corner parts opf each substrate region did not have a shape of an arc and had a shape described in Japanese patent Publication No. 1994-091628A.

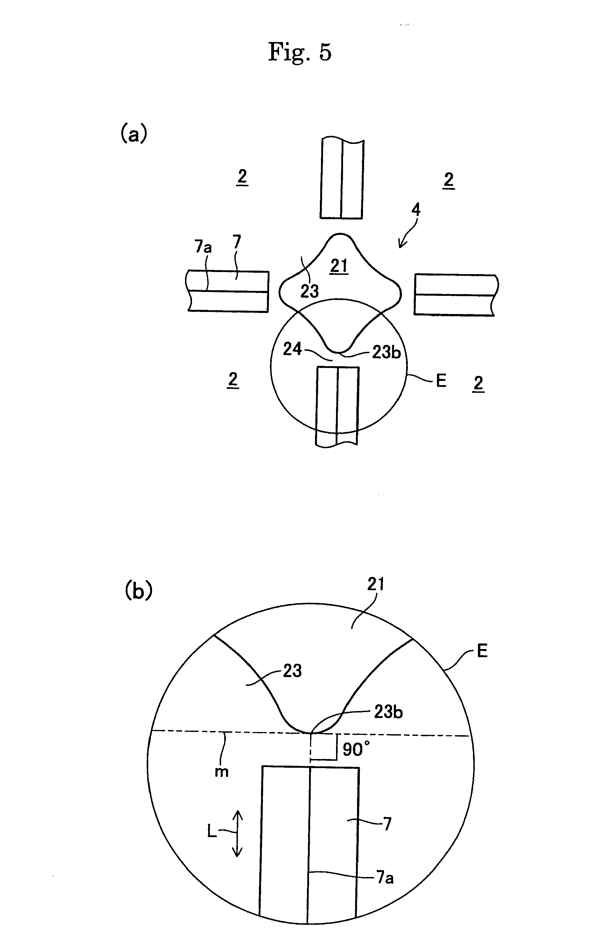

That is, as shown in Figs. 5 (a) and (b), a curved part 23 facing a spacing 21 was formed at the corner part of each substrate region. Although the end of the curved part 23 was in the vicinity of the end of the dividing groove 7, the end of the dividing groove 7 was not communicated with the spacing 21 with a non-spacing part 24 was provided therebetween. The tangential line "M" to an end 23b of the curved part 23 on the side of the dividing groove and the longitudinal direction "L" of the dividing groove 7 are made right angle, which was just the opposite to the case of the present invention (see Fig. 4).

Ten samples of the base plate were broken along the dividing grooves, respectively. As a result, the deviation of a force required for the breaking was proved to be 0.7 ± 0.3 N/mm. Further, the non-spacing part 24 between the dividing groove 7 and spacing 21 were broken in indeterminate forms to leave needle-like protrusions in eight of the ten samples.

### (Examples 2 and 3)

Test was performed according to the same procedure as the Example 1 except that the width of the opening and angle of the bottom of the groove were changed as shown in Table 1, and the results were shown in Table 1.

**Table 1**

| | Example 1 | Example 2 | Example 3 | Comparative Example 1 | Comparative Example 2 |
|---|---|---|---|---|---|
| Width of opening at surface : mm | 0.3mm | 0.1mm | 0.5mm | 0.3mm | 0.3mm |
| Angle at bottom of groove : ° | 6 0° | 2 5° | 9 0° | 6 0° | 6 0° |
| Depth of groove : mm | 0.26mm | 0.26mm | 0.26mm | 0.26mm | 0.26mm |
| Shape of spacing | Tangential Arc | Tangential Arc | Tangential Arc | Circle | Curved Arc |
| Force required for breaking : N/mm2 | 0.6±0.1 | 0.6±0.1 | 0.6±0.1 | 0.6±0.3 | 0.7±0.3 |
| Shift from dividing groove | 0/10 | 0/10 | 0/10 | 3/10 | 8/10 |

The present invention has been explained referring to the preferred embodiments , however , the present invention is not limited to the illustrated embodiments which are given by way of examples only , and may be carried out in various modes without departing from the scope of the invention.

A ceramic base plate is divided into a plurality of substrate regions 2 each having corner part 8. A dividing groove 7 is formed between the substrate regions 2 adjacent with each other. The corner part 8 of each of the substrate regions 2 faces a spacing 9B communicated with the dividing groove 7. At least a part of the corner part 8 is arc-shaped. The arc-shaped part of the corner part is tangent to a center line 7a of the dividing groove 7 at a cross point "P" of the spacing 9B with the dividing groove 7. The ceramic base plate is broken along the dividing groove 7 to produce ceramic substrates.

## Claims

1. A method of producing a plurality of ceramic substrates by breaking a ceramic base plate,
wherein said ceramic base plate comprises a plurality of substrate regions divided with each other, said substrate region comprising a corner part;
wherein a dividing groove is formed between said substrate regions adjacent with each other;
wherein said corner part of each of said substrate regions faces a spacing communicated with said dividing groove;
wherein at least a part of said corner part is arc-shaped; and
wherein said arc-shaped part of said corner part is tangent to a center line of said dividing groove at a cross point of said spacing with said dividing groove;
the method comprising the step of producing said ceramic substrates by breaking said ceramic base plate along said dividing groove.

2. The method of claim 1, wherein said dividing groove comprises a first inclined face and an opposing second inclined face viewed in a cross section perpendicular to the longitudinal direction of said dividing groove, and wherein said first and second inclined faces make an angle of 25 to 90 °.

3. The method of claim 1 or 2, wherein said dividing groove has an open width of 0.1 to 0.5 mm at a surface of said ceramic base plate.

4. The method of any one of claims 1 to 3, wherein said ceramic base plate comprises a translucent alumina ceramics.

5. The method of any one of claims 1 to 4, wherein said ceramic base plate is produced by gel casting.
